# EUROPEAN PATENT APPLICATION

(11) **EP 2 293 657 A1**
(43) Date of publication of application: **09.03.2011**
(21) Application number: 09168501.6
(22) Date of filing: 24.08.2009
(51) Int. Cl.: H05K 3/28, H05K 3/34, H01L 23/31, H01L 21/00

(54) **Electronic component and method of forming an electronic component**

(71) Applicant: Schreiner Group GmbH & Co. KG, 85764 Oberschleissheim (DE); Continental Automotive GmbH, 30165 Hannover (DE)
(72) Inventor: Rehse, Nicolaus, Dr., 85386 Eching (DE); Hartauer, Andrea, 94339 Leiblfing (DE); Horn, Rüdiger, 93455 Sattelbogen (DE); Rübekeil, Markus, 80809 München (DE); Stoian, Liviu Achim, 300284 Timisoara (RO); Vlad, Sebastian Remus, 300562 Timisoara (RO)
(74) Representative: Epping - Hermann - Fischer

(57) **Abstract**

The invention provides an electronic component (10) comprising:
- a circuit board (1),
- at least one semiconductor device (2) mounted on the circuit board (1) and protruding above a surface (1A) of the circuit board (1) and
- a synthetic foil (5) covering the semiconductor device (2) and further covering at least a surface region (11) of the surface (1A) of the circuit board (1) laterally surrounding the semiconductor device (2),
- wherein the synthetic foil (5) is formed of a material mainly comprised of a thermoplast and
- wherein the synthetic foil (5) is formed as a pocket (15) conforming to an outer shape of the semiconductor device (2) and comprising a circumferential portion (5b) which extends from an outer surface (2A) of the semiconductor device (2) to the surface (1A) of the circuit board (1) and which abuts the surface region (11) laterally surrounding the semiconductor device (2).

## Description

The invention refers to an electronic component comprising a circuit board and at least one semiconductor device mounted on the circuit board and protruding above a surface of the circuit board. The invention further refers to a method of forming an electronic component comprising a step of placing at least one semiconductor device on a circuit board, a solder material being arranged between the semiconductor device and the circuit board.

Electronic components like main boards or memory modules, for instance, comprise a circuit board on which further elements like resistors, capacitors as well as more complex devices having microelectronic integrated circuits are mounted and connected to one another.

The microelectronic integrated circuits of the semiconductor devices comprise the main part of the circuitry of the electronic component and are fabricated on the basis of wafer processing. After dicing the wafer into separate chips and, eventually, providing each chip with a housing, the respective chip or housing is mounted on a circuit board, for instance by means of a pick and place instrument. The semiconductor device comprises contact elements for soldering it to the circuit board.

One potential risk with view to the numerous closely arranged contact elements is that they could get short-circuited in case of metallic particles deposited thereon or in case of humidity, as occurring in the case of rapid variations of the ambient temperature. Metallic particles may result, for instance, from sawing circuit boards in the production process.

In order to prevent short-circuits between the contact elements of a semiconductor device mounted on a circuit board, it is conceivable to spray a lacquer or varnish onto the surface of the mounted circuit board in order to cover all contact elements with an insulating layer. However, spraying such layers onto a circuit board and subsequent drying (and thereby hardening) would significantly increase the effort, time and complexity of the production. Further drawbacks are the pollution of the production environment with the liquid to be sprayed on, or the non-uniform thickness of the sprayed-on layer which may adversely affect subsequent processing steps.

Alternatively, insulating plastic materials might be applied as a paste around the contact elements and then hardened. However, also in this case much production time would be wasted.

It is the object of the invention to provide a new technique of preventing short-circuits between contact elements of semiconductor devices mounted on circuit boards and to provide electronic components which are no longer susceptible to short-circuits caused by exposed contact elements.

This object is solved by an electronic component comprising:
- a circuit board,
- at least one semiconductor device mounted on the circuit board and protruding above a surface of the circuit board and
- a synthetic foil covering the semiconductor device and further covering at least a surface region of the surface laterally surrounding the semiconductor device,
- wherein the synthetic foil is formed of a material mainly comprised of a thermoplast and
- wherein the synthetic foil is formed as a pocket conforming to an outer shape of the semiconductor device and comprising a circumferential portion which extends from an outer surface of the semiconductor device to the surface of the circuit board and which abuts the surface region of the circuit board laterally surrounding the semiconductor device.

The electronic component comprises a synthetic foil covering the semiconductor device and further covering a surface region of the surface of the circuit board laterally surrounding the semiconductor device. In contrast to a sprayed layer of varnish usually having non-uniform thickness, the invention proposes to use a synthetic foil. A foil is a piece of material already confectioned and preshaped, thereby maintaining the uniform foil thickness. Analogously, in the method of production, such a preshaped foil having a predefined uniform thickness is placed on the semiconductor device of the electronic component. Since the foil has a uniform thickness from the beginning of the process of forming the electronic component, the uniform thickness need only be maintained during the subsequent process steps in order to obtain a uniform layer on the produced electronic component. In the simplest case, a substantially planar synthetic foil is applied such that the further manufacture of the electronic component will only involve some deformation the contour of the synthetic foil but will not substantially alter the global or local thickness of the foil.

As a result, the electronic component comprises a foil or film of synthetic material having a thickness of a uniformity hardly achievable by techniques of spraying and subsequently drying a liquid material.

The synthetic foil of the electronic components is a hot melt foil formed of a material mainly comprised of a thermoplast. This material, when temporarily heated above its softening temperature, will become ductile and workable. This property inherent to thermoplastic materials will enable the synthetic foil to adapt to the outer contours of the semiconductor device (including the shape of its contacts) mounted on the circuit board. As a consequence, the synthetic foil forms a conformal, non-planar layer of a uniform thickness. Furthermore, as the synthetic foil remains substantially unchanged during the production of the electronic component, the uniform synthetic layer obtained on the electronic component still is a foil.

In particular, the synthetic foil is formed as a pocket conforming to the shape of the semiconductor device and comprising a circumferential portion. A central portion of the synthetic foil covers an outer surface of the semiconductor device whereas the circumferential portion extends from the outer surface of the semiconductor device to a surface region of the circuit board laterally surrounding the semiconductor device. Thereby the circumferential portion covers and protects any conductive structures of the semiconductor device, like contact elements of the semiconductor device and/or solder material. Even in the case that there are no conductive elements laterally outside the body of the semiconductor device (as in the case of a ball grid array), the circumferential portion of the synthetic foil also prevents penetration of humidity or of conductive particles into the interstice between the circuit board and the semiconductor device, thereby preventing short-circuits with same reliability. The circumferential portion of course may be designed larger than required; it may also cover the entire surface of the circuit board on which the semiconductor device is mounted. However, preferably the electronic component comprises a respective piece of synthetic foil on each semiconductor device, each synthetic foil comprising a central portion on the respective device and a circumferential portion protecting its contacts and solder structures.

According to one embodiment the uniform thickness of the synthetic foil or film is in the range between 20 and 500 µm, preferably between 50 and 200 µm. Foils of these thicknesses are easily deformable upon application of heat, thereby safeguarding efficient and low-cost production of the electronic component.

According to one embodiment the synthetic foil is transparent. This allows easy optical observation and control of the state of the electronic component, such as manual inspection for fractures in the chip bodies, ruptures in the solder connections. The transparent foil further allow to read any inscription on the semiconductor devices or on the circuit board. In general, the synthetic material of the foil is electrically insulating and thermoplastic and has a uniform thickness.

According to one embodiment, the synthetic foil comprises an adhesive layer arranged at a bottom side of the material comprising the. Due to this embodiment, the foil comprises at least two layers, that is the adhesive layer and at least one upper thermoplastic layer. The thermoplastic layer will substantially ensure the stiffness of the foil at room temperature and usually will be thicker than the adhesive layer laminated on its bottom surface. Exemplary numerical thickness values are between 50 and 200 µm for the upper, thermoplastic layer and between 20 and 50 µm for the adhesive layer.

The adhesive layer facilitates safe and proper positioning of the foil on the outer surface of the semiconductor device during manufacture of the electronic component. Thereby a reliable coverage of all conductive structures surrounding the respective semiconductor device is safeguarded. In case that a synthetic foil without an adhesive layer is used, safe positioning may alternatively be achieved by at least locally preheating and/or pressing down the center portion of the foil, thereby provisionally fastening it to the top surface of the device.

According to one embodiment, the semiconductor device comprises a semiconductor chip and a housing encapsulating the semiconductor chip. In this case, the outer surface covered with the synthetic foil is a surface of the housing body and any conductive contacts protruding outside the housing are protected by the synthetic foil. Alternatively, the semiconductor device may be an uncased semiconductor chip, the synthetic foil abutting an outer main surface of the semiconductor chip directly. Uncased semiconductor chips do not comprise a case or housing of bulk plastic material surrounding the chip and supporting contact elements for connection to the circuit boards. Instead, bare chips are mounted directly without any housing.

According to one embodiment, the semiconductor device comprises contact elements connecting the semiconductor device to the circuit board, the contact elements extending laterally outside the body of the semiconductor device and being covered with the circumferential portion of the synthetic foil. Thereby the foil is sealing the semiconductor device on the circuit board.

According to a further embodiment, the electronic component comprises solder contacts connecting the semiconductor device to the circuit board, the solder contacts extending laterally outside a body of the semiconductor device and being encapsulated by the synthetic foil; the synthetic foil thus abutting their top sides and side surfaces. The solder contacts are usually formed of a solder paste or another solder material temporarily heated during production.

In the region laterally outside the body of the semiconductor device, the solder contacts may be present in addition to the contact elements laterally protruding beyond the body of the semiconductor device. Alternatively, in the region laterally surrounding the body only the solder contacts may be present. Yet alternatively, all conductive structures may be arranged below the semiconductor device, that is within its floor space. But even in this case they are still accessible by humidity and/or conductive particles. In all these cases, the synthetic film will cover the semiconductor device and any conductive structures arranged around the semiconductor device body and thus least will block, by means of its circumferential portion, any access to the interstice between the semiconductor device and the circuit board.

According to a further embodiment, the material of the synthetic foil includes a fluorescent or phosphorescent additive. Upon irradiation of UV-radiation, the additive will absorb it and re-emit visible light (for instance, blue light), thereby enabling easy and rapid visual control whether or not a synthetic film is present on a respective semiconductor device of a circuit board.

The object of the invention is further solved by a method of forming an electronic component, wherein the method comprises:
a) placing at least one semiconductor device on a circuit board, a solder material being arranged between the semiconductor device and the circuit board, and placing a synthetic foil formed of a material mainly comprised of a thermoplast on an outer surface of the semiconductor device in a position such that the synthetic foil covers the outer surface of the semiconductor device and that a circumferential portion of the synthetic foil extends beyond lateral dimensions of the semiconductor device, and
b) combinedly effecting soldering of the semiconductor device to the circuit board as well as deforming of the synthetic foil by applying heat, thereby causing deformation of the heated synthetic foil to a pocket which conforms to an outer shape of the semiconductor device and to a surface region of the circuit board laterally surrounding the semiconductor device.

According to this method, a step of applying heat required for soldering may be exploited for simultaneously deforming a preshaped (in particular planar) synthetic foil previously placed onto a semiconductor device to be protected. By application of heat to the synthetic foil, also the foil is deformed to yield a pocket conforming to the outer contours of the semiconductor device and the circuit board surface surrounding it. It is a predominant benefit of the present invention that the step of heating the solder material may be exploited for additionally heating and deforming the synthetic foil without causing any additional effort.

The material of the synthetic foil is chosen such that the same temperatures applied for soldering is also applicable for heating and thereby causing deformation of the foil, only due to the weight of the foil itself. Furthermore, by taking into account the duration and the temperature of the heat application, simultaneous deforming of the foil and soldering of the solder contact may be further optimized. Whereas usually the temperatures in a reflow oven are not usable for hardening varnishes, thermoplastic synthetics provided as a sheet of foil can now be deformed, by simply choosing the appropriate foil material in view of its softening point (the softening temperature above with the thermoplast becomes ductile and workable) and the temperature in the reflow oven.

The pre-shaped planar foil is confectioned and positioned on the semiconductor device such that the body of the semiconductor device is surrounded by a circumferential portion of the synthetic foil laterally extending beyond the dimensions of the top surface of the decice body (preferably along all four lateral directions).

Any semiconductor device placed onto the circuit board may be covered with a separate foil. The respective foil initially adheres to the respective top surface of the device via its adhesive layer or, alternately, by locally being preheated and/or pressed on (at least at a portion of the centered portion). This step of preheating is performed already before the actual heating in step b).

According to one embodiment, combined soldering of the solder contacts and deforming of the synthetic foil is performed at a temperature in the range between 150°C and 250°C. The duration of heat application may between 15 and 90 seconds, for instance about 30 seconds. However, also higher temperatures may be used, depending on the material of the synthetic foil and its softening temperature. During heat application, the polymer of the synthetic foil deforms and follows the shape of the underlying the semiconductor device of the circuit board.

According to an embodiment, step b) is performed in a reflow oven through which the circuit board supporting the semiconductor device with the synthetic foil is transported. The circuit board is continuously transported through the oven. Since the synthetic foil merely need to be placed on the semiconductor device before entering the oven, there is no increase in production time, which is a great advantage compared to conventional techniques of spraying or immersing into a varnish which would require a subsequent drying of the varnish.

Preferably, the method further comprises, between steps a) and b), a step of preforming the synthetic foil by means of a steam of heated air pressing the synthetic foil against the circuit board. The heated air stream, preferably directed vertically downside and perpendicularly to the surface of the circuit board, is bending the circumferential portion of the synthetic foil towards the circuit board. This significantly reduces the time required for bending down the laterally protruding foil portions and conforming them to the surface shape above the circuit board.

According to a further embodiment, the stream of heated air is applied through a slit nozzle arranged at an entry of the reflow oven. The slit nozzle extending along the entire width of the entry of the oven generates a curtain of hot wind blowing downwards. Since the circuit board with the semiconductor chips and the synthetic foils placed thereon is continuously moved into and through the reflow oven, the preforming step achieved by the slit nozzle does not require any additional manufacturing time. Accordingly, both the preforming step as well as the final heating of the preformed foil may be integrated in a conventional manufacturing process with almost no additional effort.

The step of preforming may be performed with an air stream heated to a temperature of between 150°C and 200°C, for instance.

Finally, the method may further include, after step b), a step of hardening the synthetic foil by applying UV-radiation. Thereby the thermoplastic polymer of the synthetic foil is made more durable and resistive to mechanical or chemical influences.

Hereinbelow, some exemplary embodiments are described with respect to the Figures.
FIG. 1 shows a schematic top view on an electronic component according to one embodiment,
FIG. 2 shows a cross-sectional view of the electronic component of FIG. 1,
FIG. 3 shows a preshaped synthetic foil as applied according to the invention,
FIG. 4 illustrates a partial cross-sectional view to FIG. 3 according to one embodiment,
FIG. 5 shows a partial cross-sectional view to FIG. 3 according to another embodiment,
FIG. 6 shows a cross-sectional view of an electronic component alternative to FIG. 2,
FIG. 7 shows a schematic view of an equipment for heating and deforming a synthetic foil covering a semiconductor device on a circuit board,
FIG. 7A shows an enlarged view of a detail of FIG. 7,
FIG. 8 shows a photograph of an equipment according to FIG. 7,
FIG. 9 shows a photograph of a circuit board with a synthetic foil covering a semiconductor device and
FIG. 10 shows another photograph of a detail of FIG. 9.

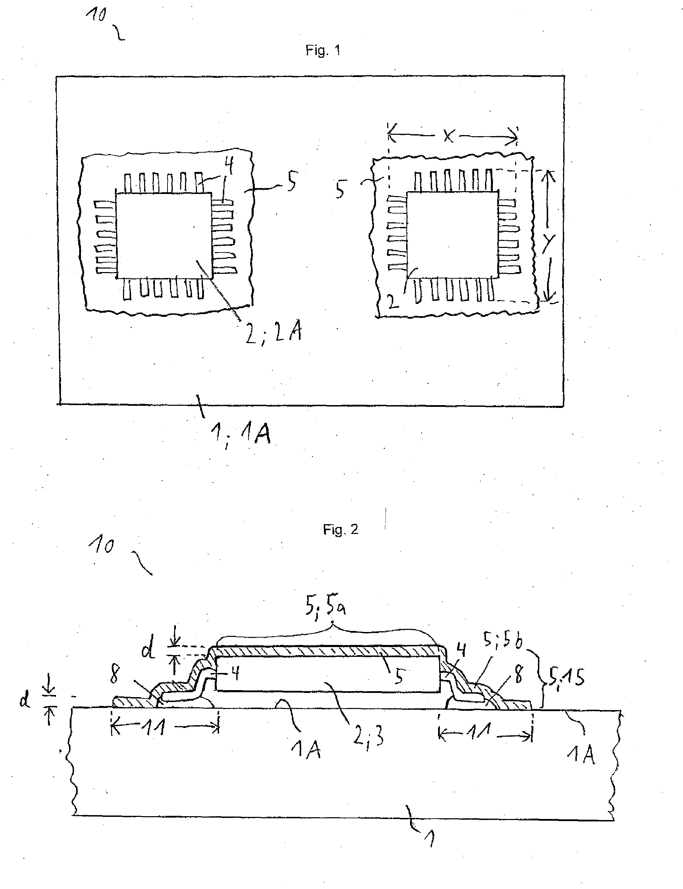

FIG. 1 shows a schematic top view on an electronic component 10 according to one exemplary embodiment. On a surface 1A (the main surface) of a circuit board 1, one or more semiconductor devices are provided. Further kinds of electronic elements also provided on the circuit board 1 are not illustrated explicitly in FIG. 1. Such further elements may be capacitors, resistors or other devices of less complexity compared to the semiconductor devices 2 which comprise an integrated circuit.

The semiconductor devices 2 may be uncased semiconductor chips (without a housing) which are mounted directly, via solder elements, to the surface 2A of the circuit board 1. Alternatively, as illustrated in FIG. 1, the semiconductor device 2 may comprise a semiconductor chip as well as a housing surrounding and protecting the semiconductor chip. The semiconductor devices 2 are surface-mounted devices (SMD), for instance. The housing may comprise a body surrounding the chip as well as contact elements 4 laterally and/or vertically protruding outside the body, as illustrated in FIG. 1 and 2. In FIG. 1, the dimensions of the body and of the contact elements 4 combinedly define the lateral dimensions x, y of the respective semiconductor device 2.

Conventionally, the contact elements 4 of the semiconductor devices are exposed to the environment. In case of humidity or conductive particles deposited on or between the contact elements 4, there is a risk of short circuits which might disturb proper operation or even cause hardware damages. As regards the conductive particles, like metal pieces, these particles may arise from sawing, drilling or otherwise mechanically treating circuit boards during production. Up to now, however, there is no way of easily and effectively protecting such exposed contacts without significantly increasing the costs, time and effort of production.

According to the invention, a synthetic foil 5 is provided on the semiconductor devices 2, thereby protecting and insulating any outer contacts from the environment.

The synthetic foil proposed to be applied is a preshaped foil already having a uniform thickness. The foil should be applied as a planar sheet with lateral dimensions sufficient for completely covering and protecting a respective semiconductor device 2 on the circuit board 1. The thickness of the foil preferably is below 500 µm, the synthetic foil thus being easily deformable and thereby conformable to topologies (vertical steps) in the shape of the housing and the contact elements 4 of the semiconductor device 2 on the circuit board 1. As the thin foil does not need to be dissolved or liquefied, even after application to the topology on the circuit board the synthetic foil 5 maintains its uniform thickness. By conforming to the outer shape of the housing and of the contact elements, the synthetic foil 5 safely prevents any electrical short circuits.

In contrast to insulating pastes which have to be applied with a comparatively large material consumption and technical effort and which need to be hardened during a long time, the synthetic foil proposed herein achieves a more efficient protection with less material consumption. On the other hand, in comparison with conventional varnishes to be sprayed onto circuit boards and requiring time-consuming drying involving the risk of thickness variations and of openings in the varnish layers, the synthetic foil proposed herein achieves a more uniform coverage of any exposed contact element and/or solder element and does not require long process times for hardening as involved in the case of drying a varnish. Moreover, any pollution of the environment or the production equipment with varnish steams is avoided.

The synthetic material of the foil essentially comprises a thermoplast. For instance, a thermoplastic material having a softening temperature of between 100°C and 200°C may be used. By heating such a thermoplastic synthetic above the softening temperature, the material begins to deform and to conform to its supporting structure. Accordingly, when the thermoplastic synthetic film is applied to the circuit board 1 supporting a respective semiconductor device 2, the bottom surface of the synthetic foil 5 conforms to the outer contours of the semiconductor device 2, thereby forming a pocket. A central portion 5a of the synthetic foil 5 remains planar on the outer surface 2A of the semiconductor device 2 whereas a circumferential portion 5b, after application to the semiconductor device on the circuit board, becomes non-planar but still maintains its uniform, predefined foil thickness d as schematically apparent from FIG. 2.

FIG. 2 shows a cross-sectional view of the electronic component 10 of FIG. 1 according to one embodiment. The cross-sectional view is taken through the center of one of the semiconductor devices 2 of FIG. 1. The synthetic foil 5 includes a central portion 5a and a circumferential portion 5b. The circumferential portion 5b is laterally surrounding the central portion 5a and is covering a surface region 11 of the surface 1a closest to the semiconductor device 2. As apparent from the shape of the synthetic foil 5, it is forming a pocket 15 above and around the semiconductor device 2, thereby preventing short circuits of conductive structures such as contact elements 4 and/or solder elements 8 connecting the semiconductor device 2 to the circuit board 1. The material of the thermoplastic foil is an insulator and may be rigid or deformable to some degree at room temperature.

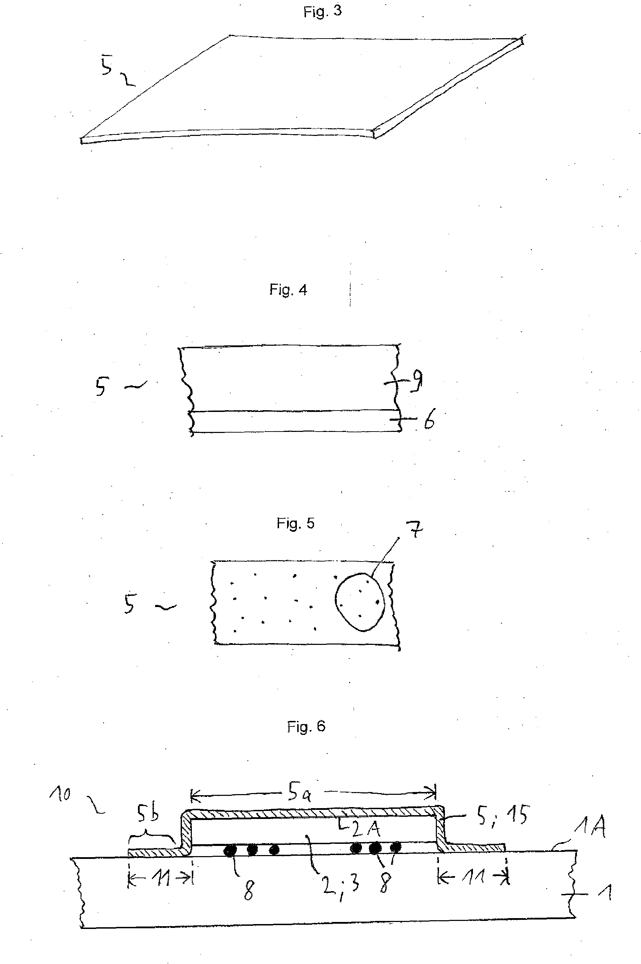

FIG. 3 illustrates a piece of synthetic foil 5 as ready for application to a semiconductor device 2 on a circuit board 1, thereby yielding the electronic component 10 proposed herein. A synthetic foil may easily be confectioned, for instance by cutting a planar foil into pieces, each piece of foil having lateral dimensions slightly larger than the lateral dimensions x, y of the respective semiconductor device 2 (FIG. 1).

FIG. 4 illustrates an embodiment of a synthetic foil 5 formed of a thermoplastic layer 9 and an adhesive layer 6 below the bottom surface of the thermoplastic layer 9. The thickness of the adhesive layer may be between 10 and 100 µm, for instance 25 µm. The thickness of the thermoplastic layer 9 may be chosen between 50 and 400 µm. The total thickness of the synthetic foil 5 is in the range between 20 and 500 µm, preferably between 50 and 200 µm.

The thermoplastic synthetic foil is a hot melt foil. The material of the foil may be chosen transparent, semitransparent or opaque.

FIG. 5 illustrates a further embodiment according to which an additive 7, indicated by a plurality of dots (representing particles, atoms or molecules, for instance), is comprised in the synthetic material of the foil. The additive is a fluorescent or phosphorescent additive which, upon treatment with UV radiation, is emitting visible light. This embodiment allows easy and rapid recognition, even in case of using transparent synthetic foils, whether a particular semiconductor device 2 on the circuit board is covered with a respective sheet of foil or not. Of course, the embodiments of FIGs. 4 and 5 may be combined with one another.

FIG. 6 illustrates another embodiment of an electronic component 10 comprising at least one semiconductor device 2 covered with a synthetic foil 5. In the embodiment of FIG. 6, the semiconductor device 2 comprises a housing with a ball grid array (serving as the solder elements 8) at its bottom side. In the region laterally outside the housing of the semiconductor device 2, no further contact structures are present. Also in this case conductive particles or humidity might enter the interstice between the circuit board and the semiconductor device and might cause short circuits. According to the invention, however, the synthetic foil 5 (chosen as described herein) is provided, thereby covering and shielding the semiconductor device 2 by means of the circumferential portion 5b of the synthetic foil 5.

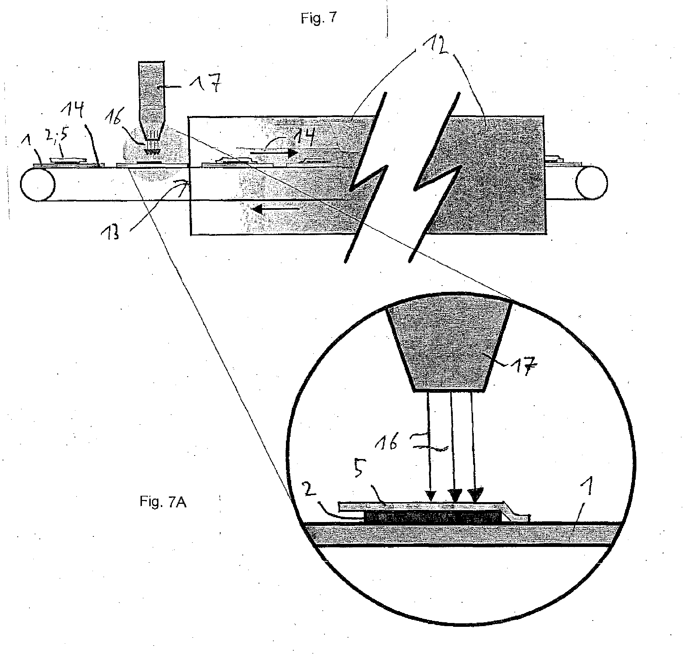

FIG. 7 illustrates a schematical cross-sectional view of an equipment for heating and deforming a synthetic foil 5 placed on a circuit board 1 supporting a semiconductor device 2. The equipment comprises a reflow oven 12 which conventionally is already required for soldering the circuit board 1 and the semiconductor device 2 to one another.

In FIG. 7, there is a transport route 14 leading through the reflow oven 12. Along the transport route 14, circuit boards 1 supporting at least one semiconductor device 2 are transported. Within the reflow oven 12, the soldering occurs at an appropriate temperature and during an appropriate heating time.

Conventionally, only the soldering is performed by means of the reflow oven 12 and the transport route 14. As proposed in the present application, however, the semiconductor device 2, before entering the reflow oven 12, is covered with a sheet of synthetic foil 5 which, for instance, may be positioned on the semiconductor device 2 by an appropriate instrument not illustrated. The synthetic foil 5 is positioned such that a central portion of the foil completely covers the outer surface of the semiconductor device and that a circumferential portion is extending around the perimeter the semiconductor device 2. Accordingly, also the synthetic foil 5 is entering the reflow oven and is thus heated above the softening temperature of the thermoplastic foil material. Thereby the foil 5 is conforming to the outer shape of the semiconductor device 2, of its contact elements 4, of the solder elements 8 and of the surface 1A of the circuit board 1 (FIG. 2 or 6).

Conventionally, a skilled person would avoid any contact of the solder elements 8 or contact elements 4 with synthetics or plastic materials, in particular with a hot melt foil as proposed herein, and would neither use a reflow oven for intentionally deforming sheets of synthetic foil of thermoplastic material directly laid on the semiconductor devices. Instead, in all cases in which a protection of the semiconductor device is desired, conventionally rather complex and time-consuming measures and apparatuses would have to be included in the processing route.

According to the present embodiment, however, in addition a synthetic foil is heated and deformed in the reflow oven. As further illustrated in FIG. 7, the synthetic foil may be preheated and at the same time pressed against the semiconductor device 2 and the circuit board 1 before entering the reflow oven 12. To this end a slit nozzle 17 generating a stream of heated air 16 is provided at or before the entry 13 of the reflow oven 12. As more clearly apparent from the enlarged detailed view of FIG. 7A, the slit nozzle 17 is generating a stream of heated air 16 directed perpendicularly towards the outer surfaces of the semiconductor device 2 and of the circuit board 1. As soon as the synthetic foil 5, when being transported on the semiconductor device 2 along the transport route 14, arrives at the heated air stream, it is pressed onto the outer surface 2A of the semiconductor device 2 and the circumferential portion 5B of the synthetic foil 5 is bent towards the upper surface 1A of the circuit board 1. Accordingly, the circumferential portion is approaching the contact elements 4, the solder elements 8 and the upper surface 1A (FIG. 2 or 6). The air stream is heating and deforming the foil material yet before the synthetic foil 5 actually enters the reflow oven 12. Due to this step of preforming the synthetic foil, it is prevented that the circumferential portion 5b of the synthetic foil 5 might form drops of hot melt material before actually contacting the contact elements, the solder elements and/or the surface 1A.

Undesired melting of the foil material and formation of drops of hot melt material at the outer edges of the foil sheet would impede proper deformation of the foil material and safe coverage of the contact elements 4 and/or solder elements 8 with a foil material layer of a uniform thickness. Due to the heated air stream, such adverse effects are reliably prevented. Moreover, as the synthetic foil 5 merely passes below the heated air stream only for a short instant during entering the oven, no additional process time is required.

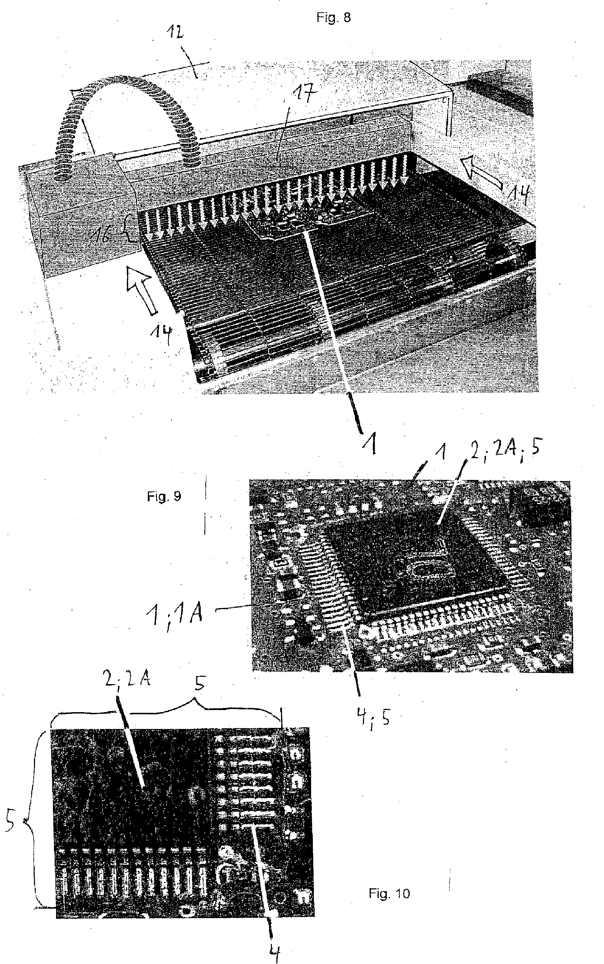

FIG. 8 illustrates a photograph of an exemplary equipment comprising a reflow oven 12, a slit nozzle 17 and a transport route 14. A circuit board 1 is illustrated on the transport route 14 in a position just passing through a heated air stream 16 directed downwards. The heated air stream is designed as a curtain of heated air covering the whole width of the entry of the reflow oven 12. At the left side of the slit nozzle, a generator of the heated air stream is depicted. For adjusting the intensity and the duration of the preheating and deforming of the foil material by the stream of heated air 16, the dimensions of the slit nozzle of FIGs. 7 and 7A may be chosen optimized appropriately. For instance, the width of the slit nozzle opening, in direction of the transport route, may be about 5 mm or in any range suitable for the desired preheating and/or preforming duration. Also, the distance between the synthetic foil and the lower opening of the slit nozzle 17 may be chosen appropriately, for instance between 3 and 5 cm. Furthermore, an airflow rate of between 10 and 40 1/min and a temperature of the air stream of between 150 and 200 °C may be chosen, for instance.

FIG. 9 depicts a photograph of a circuit board 1 supporting the semiconductor device 2 as well as further electronic elements. Contact elements 4 are arranged at the four edges of the body of the semiconductor device 2 from which they are protruding laterally. As apparent from the irregular gray scale value of the outer surface 2A of the semiconductor device, this surface is covered with a synthetic foil 5 which also extends above and beyond the contact elements 4. Accordingly, the outer edges of the synthetic foil 5 are located at a similar position as depicted in the schematic view of FIG. 1. As further apparent from FIG. 9, the synthetic foil 5 is conforming to the outer shape of the contact elements 4 and of the semiconductor device 2. Thereby a uniform coverage by the foil material and a reliable protection from short circuits are achieved.

As furthermore apparent from FIG. 9, the synthetic foil 5 is transparent and does not obscure the surfaces of the structures covered therewith. For instance, the number "70" printed on the outer surface 2A of the semiconductor device 2 is still readable. Any damages, such as fractures in the housing of the semiconductor device or interrupted contacts between some contact elements and the surface of the circuit board 1, are still visible through the transparent synthetic foil.

FIG. 10 illustrates another photograph showing a top view on a detail of FIG. 9. FIG. 10 shows a corner with two adjoining edges of the body of a semiconductor device 2 from which respective rows of contact elements 4 protrude in lateral directions. Both the outer surface 2A as well as the surface region 11 (FIG. 2 or 6), which laterally surrounds the body of the semiconductor device 2 and supports any solder elements and/or contact elements, are covered with the synthetic foil. Of course, the synthetic foil not be transparent. Finally, in FIG. 10 the approximate lateral positions of the outer edges of the synthetic foil 5 outside the semiconductor device 2 are indicated.

### References

- 1: circuit board
- 1A: surface
- 2: semiconductor device
- 2A: outer surface
- 3: semiconductor chip
- 4: contact element
- 5: synthetic foil
- 5a: central portion
- 5b: circumferential portion
- 6: adhesive layer
- 7: additive
- 8: solder element
- 9: thermoplastic layer
- 10: electronic component
- 11: surface region
- 12: reflow oven
- 13: entry
- 14: transport route
- 15: pocket
- 16: stream of heated air
- 17: slit nozzle
- d: predefined foil thickness
- x, y: lateral dimensions

## Claims

1. An electronic component (10) comprising:
- a circuit board (1),
- at least one semiconductor device (2) mounted on the circuit board (1) and protruding above a surface (1A) of the circuit board (1) and
- a synthetic foil (5) covering the semiconductor device (2) and further covering at least a surface region (11) of the surface (1A) of the circuit board (1) laterally surrounding the semiconductor device (2),
- wherein the synthetic foil (5) is formed of a material mainly comprised of a thermoplast and
- wherein the synthetic foil (5) is formed as a pocket (15) conforming to an outer shape of the semiconductor device (2) and comprising a circumferential portion (5b) which extends from an outer surface (2A) of the semiconductor device (2) to the surface (1A) of the circuit board (1) and which abuts the surface region (11) laterally surrounding the semiconductor device (2).

2. The electronic component of claim 1,
**characterised in that** the synthetic foil (5) has a predefined foil thickness (d) of between 20 and 500 µm, preferably of between 50 to 200 µm.

3. The electronic component of claim 1 or 2,
**characterised in that** the synthetic foil (5) is transparent.

4. The electronic component of one of claims 1 to 3,
**characterised in that** the synthetic foil (5) comprises an adhesive layer (6) arranged at a bottom side of the material comprised of the thermoplast.

5. The electronic component of one of claims 1 to 4,
**characterised in that** the semiconductor device (2) comprises a semiconductor chip (3) and a housing encapsulating the semiconductor chip (3), the synthetic foil (5) abutting an outer main surface (2A) of the housing.

6. The electronic component of one of claims 1 to 5,
**characterised in that** the semiconductor device (2) comprises contact elements (4) connecting the semiconductor device (2) to the circuit board (1), the contact elements (4) extending laterally outside a body of the semiconductor device (2) and being covered with the synthetic foil (5).

7. The electronic component of one of claims 1 to 6,
**characterised in that** the electronic component (10) comprises solder contacts (8) connecting the semiconductor device (2) to the circuit board (1), the solder contacts (8) extending laterally outside a body of the semiconductor device (2) and being covered with by the synthetic foil (5).

8. The electronic component of one of claims 1 to 7,
**characterised in that** the material of the synthetic foil (5) includes a fluorescent or phosphorescent additive (7).

9. A method of forming an electronic component (10), wherein the method comprises:
a) placing at least one semiconductor device (2) on a circuit board (1), a solder material (8) being arranged between the semiconductor device and the circuit board, and placing a synthetic foil (5) formed of a material mainly comprised of a thermoplast on an outer surface (2A) of the semiconductor device (2) in a position such that the synthetic foil (5) covers the outer surface (2A) of the semiconductor device (2) and that a circumferential portion (5b) of the synthetic foil (5) extends beyond lateral dimensions (x, y) of the semiconductor device (2), and
b) combinedly effecting soldering of the semiconductor device (2) to the circuit board (1) as well as deforming of the synthetic foil (5) by applying heat, thereby causing deformation of the heated synthetic foil (5) to a pocket (15) which conforms to an outer shape of the semiconductor device (2) and to a surface region (11) of the circuit board (1) laterally surrounding the semiconductor device (2).

10. The method of claim 9,
**characterised in that** the combined soldering and deforming is performed at a temperature of between 150° C and 250° C.

11. The method of claim 9 or 10,
**characterised in that** the step b) is performed in a reflow oven (12) through which the circuit board (1) supporting the semiconductor device (2) with the synthetic foil (5) is transported.

12. The method of one of claims 9 to 11,
**characterised in that** the method further includes, between steps a) and b), a step of preforming the synthetic foil (5) by means of a stream of heated air (16) pressing the synthetic foil (5) against the semiconductor device (2) and bending the circumferential portion (5b) of the synthetic foil (5) towards the surface (1A) of the circuit board (1).

13. The method claim 12,
**characterised in that** the stream of heated air (16) is applied through a slit nozzle (17) arranged at an entry (13) of the reflow oven (12).

14. The method of claim 12 or 13,
**characterised in that** a stream of heated air (16) having a temperature of between 150° C and 200° C is applied.

15. The method of one of claims 9 to 14,
**characterised in that** the method, after step b), includes a step of hardening the pocket (15) formed of the synthetic foil (5) by applying UV-radiation.
